# EUROPEAN PATENT APPLICATION

(11) **EP 1 635 416 A1**
(43) Date of publication of application: **15.03.2006**
(21) Application number: 05380168.4
(22) Date of filing: 27.07.2005
(51) Int. Cl.: H01M 10/04, H01M 2/02

(54) **Secondary battery with package shell made of printed circuit board material**

(30) Priority: 09.09.2004 CN 04173757
(71) Applicant: Antig Technology Co., Ltd., 114 Taipei (TW)
(72) Inventor: Shu, His-Ming, Hsin Chuang City Taipei Hsien (TW); Chen, Cheng-Hsin, 5f, No. 5, Taipei (TW); Shen, Ko-Chen, Taipei (TW)
(74) Representative: De Pablos Riba, Julio

(57) **Abstract**

The present invention is a secondary battery comprising the package shell, secondary battery core component and electrolyte. The package shell is made of the print circuit board (PCB) material and encloses the secondary battery core component. The electrolyte is filled inside the enclosed space of package shell. The secondary battery core component comprises the positive electrode, isolation membrane and negative electrode, all laminated in sequence from top to down. The positive electrode comprises at least the first substrate which is respectively covered by the first thin metal layers on both the top side and bottom side. The negative electrode comprises at least the second substrate which is respectively covered by the second thin metal layers on the top side and bottom side.

## Description

### FIELD OF THE INVENTION

The present invention is related to a secondary battery, especially to a secondary battery manufactured by the print circuit board (PCB) process, and utilizing the double-sided copper foil of copper clad laminate (CCL) as the material of positive and negative electrodes of the secondary battery.

### BACKGROUND OF THE INVENTION

The used secondary battery structure like rechargeable lithium battery and nickel metal hydride utilizes a metallic package of a closed shell to seal the battery composition like the positive electrode, negative electrode, isolation membrane and electrolyte into the metallic shell. It therefore limits the secondary battery structure and fails to use the PCB process to manufacture the secondary battery. Again, the positive and negative electrodes used in the conventional secondary battery structure have not disclosed the present invention's double-sided copper foil of CCL structure.

The inventor investigating the positive and negative structure of the secondary battery by utilizing a similar double-sided copper foil of CCL is then convenient to manufacture the secondary battery in the PCB process.

### SUMMARY OF THE INVENTION

The present invention is to provide a secondary battery manufactured by the PCB process and utilize the double-sided copper foil of copper clad laminate (CCL) as the material of positive and negative electrodes of the secondary battery.

To achieve the above purpose, the present invention provides a secondary battery comprising the secondary battery core component which comprises the positive electrode, isolation membrane, and negative electrode, wherein the positive electrode, isolation membrane and negative electrode are laminated in sequence, and the positive again comprises at least the first substrate which is respectively covered by the first thin metal layers on both the top side and bottom side; the negative electrode comprises at least the second substrate which is respectively covered by the second thin metal layers on the top side and bottom side; the package shell is the PCB material and encloses the secondary battery core component; the electrolyte is filled inside the enclosed space of the package shell.

In order to make the people familiar with the art understand the objects, characteristics and improvements, the present invention is described in details by way of the following embodiments and attached figures.

### BRIEF DESCRIPTION OF THE DRAWINGS

These and other modifications and advantages will become even more apparent from the following detained description of a preferred embodiment of the invention and from the drawings in which:
Figure 1 shows the appearance of the present invention secondary battery;
Figure 2 shows the cross-section along the AA line of FIG. 1;
Figure 3 shows the structure of the positive electrode of the present invention secondary battery; and
Figure 4 shows the structure of negative electrode of the present invention secondary battery.

### DETAILED DESCRIPTION OF THE INVETION

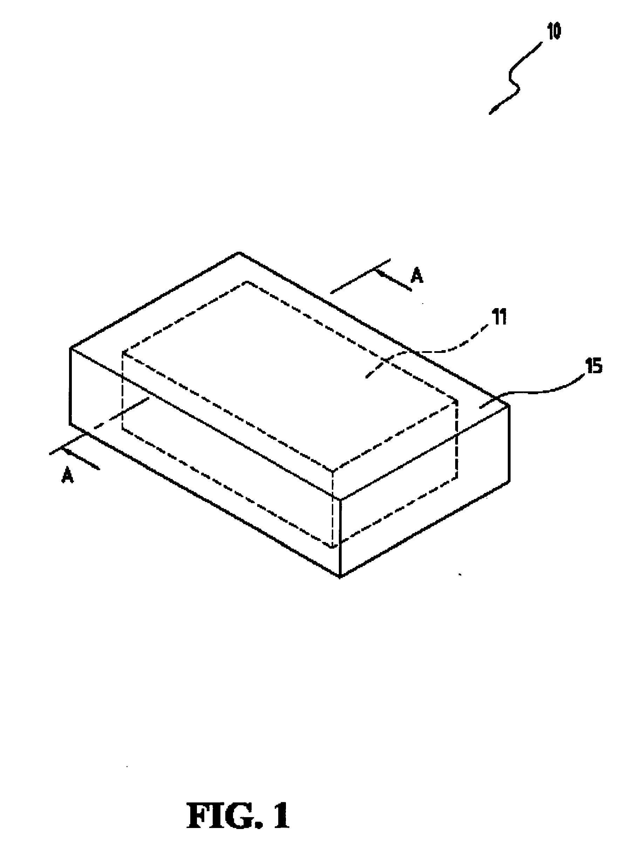

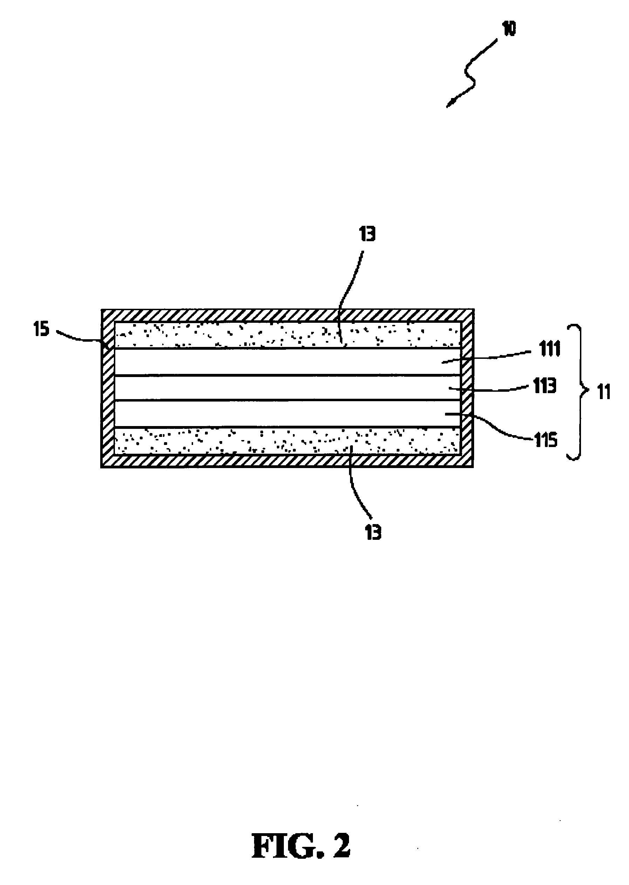

FIG. 1 and FIG.2 respectively shows the appearance of the present invention secondary battery and the cross-section along the AA line of FIG. 1. The present invention secondary battery 10 mainly comprises secondary battery core component 11, electrolyte 13 and package shell 15, wherein secondary battery core component 11 and electrolyte 13 are both enclosed inside package shell 15. The present invention's package shell 15 uses the PCB as the material and the embodiment of package shell 15 is possible to use the PCB process to respectively form the PCB into the n-type of top shell and bottom shell and then encloses them as a shell with empty space inside by the PCB process. Secondary battery core component 11 mainly comprises positive electrode 111, isolation membrane 113 and negative electrode 115, wherein positive electrode 111, isolation membrane 113 and negative 115 are laminated in sequence. In assembling the present invention secondary battery, secondary battery core component 11 is placed inside the space of the n-type of top shell and bottom shell and electrolyte 13 is also filled into the space of the n-type of top shell and bottom shell and therefore the top shell and bottom shell are enclosed.

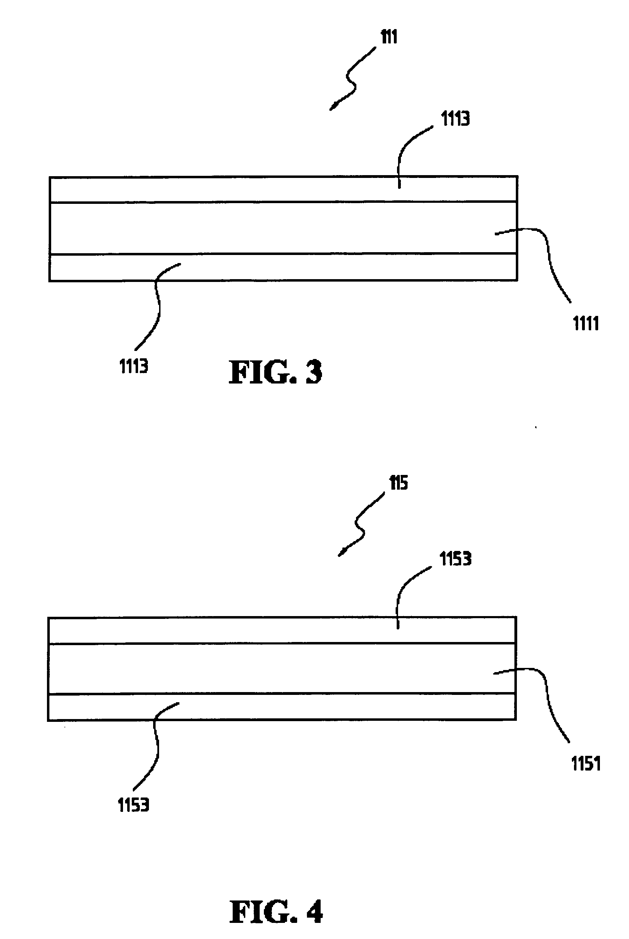

The present invention secondary battery 10 is emphasized on the structures of positive electrode 111 and negative electrode 115, first referring to FIG. 3 showing the structure of positive electrode of the present invention secondary battery. In FIG. 3, positive electrode 111 mainly comprises first substrate 1111 and first thin metal layers 1113 which respectively cover on the top side and bottom side of first substrate 1111. The present invention's first substrate 1111 is possible to use the PCB material like FR4 or flexible print circuit board (FPC). The material of first thin metal layers 1113 is possible to use copper or aluminum. Accordingly, the double-sided CCL is possibly used as the material of positive electrode 111 based on the structure property of positive electrode 111.

FIG. 4 shows the structure of negative electrode of the present invention secondary battery. In FIG. 4, negative electrode 115 mainly comprises second substrate 1151 and second thin metal layers 1153 which respectively cover on the top side and bottom side of second substrate 1151. The present invention's second substrate 1151 is possible to use the PCB material like FR4 or flexible print circuit board (FPC). The material of second thin metal layers 1153 is possible to use copper or aluminum. Accordingly, the double-sided aluminum foil of substrate is possibly used as the material of negative electrode 115 based on the structure property of negative electrode 115.

According to the disclosed structure of the present invention secondary battery 10, those disclosed embodiments or other possible embodiments practiced by the people who are skilled in the art to produce the rechargeable lithium battery, nickel metal hydride or lithium polymer chargeable batteries based on the embodiment of secondary battery 10 are within the scope of the present invention. Taking the embodiment of rechargeable lithium battery as one example, the present invention's positive electrode 111 comprises, except the above first substrate 1111 and first thin metal layers 1113, the active material of LiCoO2 or LiMn204. Again, the present invention's negative electrode 115 comprises, except the above second substrate 1151 and second thin metal layers 1153, the carbon active material. Then, piling-up positive electrode 111, isolation membrane 113 and negative electrode 115 from top to down in sequential lamination forms a structure, meanwhile, choosing positive electrode 111, isolation membrane 113 and negative electrode 115 with flexible physical property is possible to roll up to produce secondary battery core component 11. In case of choosing positive electrode 111, isolation membrane 113 and negative electrode 115 without flexible physical property, it is possible to laminate the positive electrode 111, isolation membrane 113, negative electrode 115, isolation membrane 113, positive electrode 111, isolation membrane 113, negative electrode 115... into a secondary battery core component 11.

Although the present invention has been disclosed one embodiment as the above, it does not imply to limit the present invention, any person who is skilled the art could make any change or modification within the spirit and scope of the present invention, however, it is belongs to the scope of the present invention, the protective scope of the present invention is defined by the following claims.

## Claims

1. A secondary battery, comprising:
A secondary battery core component, comprising a positive electrode, an isolation membrane, a negative electrode, wherein the positive electrode, isolation membrane and negative electrode are laminated in sequence; and the positive electrode, al least comprising a first substrate which is respectively covered by first thin metal layers on the top side and bottom side of the first substrate; the negative electrode, at last comprising a second substrate which is respectively covered by second thin metal layers on the top side and bottom side of the second substrate; a package shell, being a print circuit board (PCB) material and enclosing the secondary battery core component; an electrolyte, been filled inside the enclosed space of the package shell.

2. The secondary battery of claim 1, wherein the first substrate is a PCB material.

3. The secondary battery of claim 1, wherein the second substrate is a PCB material.

4. The secondary battery of claim 1, wherein the material of the first thin metal layers is the copper metal or aluminum metal.

5. The secondary battery of claim 1, wherein the material of the second thin metal layers is the copper metal or aluminum metal.

6. The secondary battery of claim 1, wherein the positive electrode at least comprises a double-sided copper foil of copper clad laminate (CCL).

7. The secondary battery of claim 1, wherein the negative electrode at least comprises a double-sided aluminum foil of substrate.

8. The secondary battery of claim 2, wherein the material of the PCB is FR4 or flexible print circuit board (FPC).

9. The secondary battery of claim 3, wherein the material of the PCB is FR4 or FPC.

10. The secondary battery of claim 1, wherein the secondary battery is a nickel metal hydride.

11. The secondary battery of claim 1, wherein the secondary battery is nickel metal hydride.

12. The secondary battery of claim 1, wherein the secondary battery is a lithium polymer rechargeable battery.
